# EUROPÄISCHE PATENTSCHRIFT

(11) **EP 1 592 072 B1**
(45) Veröffentlichungstag und Bekanntmachung des Hinweises auf die Patenterteilung: **19.08.2015**
(21) Anmeldenummer: 05006138.1
(22) Anmeldetag: 21.03.2005
(51) Int. Cl.: H01L 33/20, H01L 33/38

(54) **Halbleiterchip für die Optoelektronik und Verfahren zu dessen Herstellung**
Optoelectronic semiconductor chip and method of fabricating the same
Dispositif semiconducteur optoélectronique et son procédé de fabrication

(30) Priorität: 30.04.2004 DE 102004021175
(43) Veröffentlichungstag der Anmeldung: 02.11.2005
(73) Patentinhaber: OSRAM Opto Semiconductors GmbH, 93055 Regensburg (DE)
(72) Erfinder: Windisch, Reiner, 93186 Pettendorf (DE); Wirth, Ralph, 93186 Pettendorf-Adlersberg (DE); Wegleiter, Walter, 93152 Nittendorf (DE)
(74) Vertreter: Epping - Hermann - Fischer

(56) Entgegenhaltungen:
- WO-A-02/13281
- DE-A1- 10 147 887
- DE-A1- 10 224 219
- JP-A- 1 138 768
- JP-A- 4 015 965
- JP-A- 4 159 784
- JP-A- 6 334 213
- JP-A- 7 038 146
- JP-A- 7 106 631
- US-A1- 2003 116 771

## Beschreibung

Die vorliegende Erfindung betrifft einen Halbleiterchip für die Optoelektronik gemäß dem Oberbegriff des Patentanspruches 1 sowie ein Verfahren zum gleichzeitigen herstellen einer Mehrzahl derartiger Halbleiterchips.

In der WO 02/13281 ist beispielsweise ein Halbleiterchip für die Optoelektronik offenbart, der eine mit einem Trägersubstrat verbundene Dünnfilmschicht aufweist, in der vom Trägersubstrat her mindestens eine Kavität und dadurch eine Vielzahl von Mesen ausgebildet ist. Die Anzahl der Mesen beträgt z.B. mehr als 80.

Diese Vielzahl von Mesen auf der dem Trägersubstrat zugewandten Seite der Dünnfilmschicht bewirkt einerseits vorteilhafterweise, dass die Dünnfilmschicht an ihrer Verbindungsseite zum Trägersubstrat hin Anpressflächen aufweist, die gegenüber der Gesamtquerschnittsfläche des Chips kleinflächig sind. Die Anpressflächen haben den Vorteil, dass in ihrem Bereich ein vergleichsweise großer lokaler Druck erzeugt werden kann, der für ein sicheres Verbinden von Trägersubstrat und Dünnfilmschicht förderlich ist. Gleichzeitig aber kann der Druck auf die Dünnfilmschicht ausreichend gering gehalten werden, um die Gefahr einer Schädigung der Dünnfilmschicht beim Verbinden mit dem Trägersubstrat soweit wie möglich auszuschließen.

Ein weiterer Vorteil ist, dass die Fläche der Dünnfilmschicht auf der zum Trägersubstrat gewandten Seite der Dünnfilmschicht aufgrund der Kavität vergrößert wird, was ebenfalls zur Verbesserung der Verbindung zwischen Trägersubstrat und Dünnfilmschicht führen kann. Überdies steht die Kavität zur Aufnahme von überschüssigem Klebstoff oder Lötmaterial zur Verfügung, was deren Dosierung vorteilhafterweise weniger kritisch macht. Außerdem werden durch die Mesen vorteilhafterweise Seitenflächen geschaffen, an denen ein Teil der von der aktiven Zone der Dünnfilmschicht emittierten Strahlung so umgelenkt wird, dass sie innerhalb des Austrittskegels des Halbleiterchips auf die vom Trägersubstrat abgewandte Austrittsfläche der aktiven Dünnfilmschicht auftrifft. Die Reflexion an den Seitenflächen der Mesen tritt hierbei teilweise oder ganz an die Stelle der Reflexion an einer durchgehenden ebenen Reflexionsschicht.

In der WO 02/13281 ist ebenfalls offenbart, elektrische Kontaktflächen auf der dem Trägersubstrat zugewandten Seite der Dünnfilmschicht nur im Bereich der Anpressflächen und zudem außerhalb von Bereichen gegenüber von elektrischen Kontaktflächen, die auf der vom Trägersubstrat abgewandten Seite der Dünnfilmschicht angeordnet sind, anzuordnen. Dadurch entstehen jedoch insbesondere zwischen den einzelnen Mesen Bereiche, in die kein oder nur relativ wenig Strom eingespeist werden kann, so dass ein für eine Lichterzeugung verwendeter Bereich der Dünnfilmschicht lateral auf eine relativ geringe Teilfläche des gesamten Halbleiterchips eingeschränkt wird. Dies hat zur Folge, dass die Strombelastbarkeit der Halbleiterchips relativ niedrig sein kann bzw. dass der Halbleiterchip mit einer relativ hohen Stromdichte beaufschlagt wird. Eine relativ hohe Stromdichte kann unvorteilhafterweise Alterungsprozesse, wie zum Beispiel einen Anstieg der Vorwärtsspannung mit zunehmender Betriebsdauer, begünstigen.

DE 101 47 887 A1 (OSRAM OPTO SEMICONDUCTORS GMBH [DE], 30. April 2003) offenbart ein strahlungsemittierendes Halbleiterbauelement mit einem Halbleiterkörper, der eine strahlungserzeugende aktive Schicht aufweist, mit einem zentralen Vorderseitenkontakt auf einer Oberseite des Halbleiterkörpers und einem Rückseitenkontakt auf einer Rückseite des Halbleiterkörpers zum Einprägen eines Stroms in den die aktive Schicht enthaltenden Halbleiterkörper, wobei der Rückseitenkontakt eine Mehrzahl voneinander beabstandeter Kontaktstellen umfasst. In einer Ausführungsform wird die Rückseite des Halbleiterkörpers vor dem Bonden auf einen Träger in ein Muster von abgeschnittenen Kegelstümpfen strukturiert, die durch Gräben voneinander getrennt sind.

Eine Aufgabe der vorliegenden Erfindung ist es, einen Halbleiterchip der eingangs genannten Art bereitzustellen, der eine verbesserte Strahlungsemissionseffizienz, das heißt eine verbesserte Strahlungsintensität pro verbrauchter elektrischer Leistungseinheit aufweist. Eine weitere Aufgabe der vorliegenden Erfindung ist das Bereitstellen eines Verfahrens zur Herstellung eines derartigen Halbleiterchips.

Diese Aufgabe wird mit einem Halbleiterchip gemäß Patentanspruch 1 beziehungsweise durch ein Verfahren gemäß Patentanspruch 15 gelöst. Bevorzugte Weiterbildungen und vorteilhafte Ausgestaltungen der Erfindung sind Gegenstand der abhängigen Ansprüche. Der Offenbarungsgehalt der Patentansprüche wird hiermit ausdrücklich in diese Beschreibung aufgenommen.

Gemäß einer ersten Lösung des der Erfindung zugrundeliegenden Problems definiert der Graben auf der Rückseite der Dünnfilmschicht einen einzigen Teilbereich, der außerhalb von Bereichen, die mit der Vorderseitenkontaktstruktur überlappen, liegt. Insbesondere ist vorgesehen, dass der Graben den Teilbereich in einer Haupterstreckungsebene der Rückseite zumindest weitestgehend von den Bereichen, die gegenüber der Vorderseitenkontaktstruktur liegen, trennt, wobei er bevorzugt im wesentlichen entlang von Rändern der Bereiche, die gegenüber der Vorderseitenkontaktstruktur liegen, verläuft. Der Graben weist zur Umlenkung der elektromagnetischen Strahlung Innenwände auf, die bezüglich einer Haupterstreckungsebene der Dünnfilmschicht schräg stehen.

Die Innenwände verlaufen mit Vorteil derart, dass eine vielfache interne Reflexion weitestgehend vermieden und ein verglichen mit einem Halbleiterchip ohne Graben größerer Anteil der elektromagnetischen Strahlung aus dem Chip ausgekoppelt wird.

Desweiteren verlaufen die Innenwände bevorzugt derart, dass Strahlung aus einem Bereich der Dünnfilmstruktur zwischen dem Teilbereich und der Abstrahlseite, die auf Innenwände trifft, von diesen in den Bereich der Dünnfilmstruktur zwischen dem Teilbereich und der Abstrahlseite zurückreflektiert wird. Vorteilhafterweise trifft diese zurückreflektierte Strahlung dadurch auf der Abstrahlseite nicht auf die Vorderseitenkontaktstruktur, von der sie in der Regel absorbiert werden würde.

Auf der Rückseite sind bevorzugt nur in dem Teilbereich elektrische Rückseitenkontakte ausgebildet. Dadurch wird erreicht, dass im mit der Vorderseitenkontaktstruktur überlappenden Bereich der Dünnfilmschicht, das heißt in den Bereichen zwischen der Vorderseitenkontaktstruktur und der Rückseite elektromagnetische Strahlung nicht oder zumindest mit signifikant geringerer Intensität erzeugt wird als in den Bereichen zwischen dem Teilbereich und der Abstrahlseite, d. h. in Bereichen der Dünnfilmschicht, die in Draufsicht auf die Dünnfilmschicht neben der Vorderseitenkontaktstruktur liegen.

Bei dem Halbleiterchip wird durch den Graben nicht eine Vielzahl von Mesen, sondern ein einziger Teilbereich definiert, in dem Rückseitenkontakte ausgebildet sind. Da der Teilbereich eine relativ große zusammenhängende Fläche aufweist, über welche die Rückseite elektrisch leitend kontaktiert werden kann, weist der Halbleiterchip eine relativ hohe Strombelastbarkeit auf. Zudem verläuft der Strom hauptsächlich oberhalb des Teilbereichs durch die Strahlung emittierende Zone, das heißt zwischen dem Teilbereich und der Abstrahlseite der Dünnfilmschicht. Die dadurch generierte Strahlung wird durch den Graben zumindest teilweise daran gehindert, in den Bereich, der von der Vorderseitenkontaktstruktur überdeckt ist, zu gelangen. Der Graben erfüllt somit mehrere vorteilhafte Funktionen gleichzeitig und ist auf diese Weise in einer besonders effektiven Weise eingesetzt, was zu einem verbesserten Halbleiterchip und insbesondere zu einer signifikanten Steigerung der emittierten Strahlungsleistung des Halbleiterchips führen kann.

Gemäß einer zweiten Lösung des der Erfindung zugrundeliegenden Problems wird durch den mindestens einen Graben eine Mehrzahl von Teilbereichen definiert, die außerhalb von Bereichen der Dünnfilmschicht, die mit der Vorderseitenkontaktstruktur überlappen, liegen. In Draufsicht auf die Dünnfilmschicht ist jeder dieser Teilbereiche zumindest an einer Seite abgesehen von einem eventuell noch dazwischen angeordneten Teil des Grabens direkt benachbart zu einem mit der Vorderseitenkontaktstruktur überlappenden Bereich der Dünnfilmschicht. Es hat sich gezeigt, dass, solange diese Bedingung erfüllt ist, die Vorteile einer internen Umlenkung an zusätzlichen Innenwänden eines Grabens und einer damit verbundenen verbesserten Auskopplung der Strahlung gegenüber möglichen Nachteilen durch eine verringerte Strombelastbarkeit und eine verringerte intern erzeugte Strahlungsintensität überwiegen können.

Bevorzugt bedeckt jeder Teilbereich eine Fläche von größer als oder gleich (35 x 35) µm². Bei einer weiteren bevorzugten Ausführungsform weist jeder Teilbereich eine Fläche von mindestens (40 x 40) µm² auf. Vorteile von möglichst großen Teilbereichen wurden vorhergehend bereits erläutert.

Der Graben weist mit besonderem Vorteil eine Tiefe auf, die kleiner als eine halbe Dicke der Dünnfilmschicht ist. Dabei ist die Tiefe des Grabens besonders bevorzugt so gering, dass dieser die elektromagnetische strahlungsemittierende Zone nicht beschädigt, insbesondere nicht durchtrennt wird. Vorzugsweise dringt der Graben nicht in die strahlungsemittierende Zone ein. Es wurde festgestellt, dass ein Eindringen in die oder Durchtrennen der strahlungsemittierenden Zone zu einer Bildung von nicht strahlenden Rekombinationszentren an den durch den Graben freigelegten Grenzflächen der strahlungsemittierenden Zone führt, was den internen Wirkungsgrad und die Strahlungsausbeute des Halbleiterchips merklich reduziert. Der Graben ist bei einer vorteilhaften Ausführungsform zwischen einschließlich 0,5 und einschließlich 3 µm tief.

Weiterhin wurde festgestellt, dass die Strahlung effizienter aus dem Halbleiterchip ausgekoppelt werden kann, wenn Haupterstreckungsebenen der Innenwände des Grabens mit einer Haupterstreckungsebene der Dünnfilmschicht einen Neigungswinkel von kleiner als oder gleich 45° einschließen. Besonders bevorzugt beträgt dieser Neigungswinkel zwischen einschließlich 15° und einschließlich 35°. Demnach ist ein Aspekt der vorliegenden Erfindung, dass der Graben verglichen mit Halbleiterchips gemäß dem Stand der Technik kürzer ist, relativ große Teilbereiche definiert, weniger tief ausgebildet ist und/oder Innenwände aufweist, deren Haupterstreckungsebenen einen relativ kleinen Neigungswinkel haben.

Eine zusätzliche vorteilhafte Umlenkung der Strahlung wird in einer weiteren Ausführungsform der Erfindung erreicht, in dem die Seitenflanken zumindest in einem an die Rückseite angrenzenden Flankenbereich bezüglich einer Haupterstreckungsebene der Dünnfilmschicht angeschrägt sind, das heißt schräg verlaufen. Haupterstreckungsebenen der schräg verlaufenden Teile der Seitenflanken sind besonders bevorzugt um einen Abschrägwinkel von größer als oder gleich 45° zur Senkrechten der Haupterstreckungsebene der Dünnfilmschicht geneigt. Diese Maßnahme führt zu einer zusätzlichen vorteilhaften Umlenkung der elektromagnetischen Strahlung von den Seitenflanken weg, wodurch vorteilhafterweise ein geringerer Anteil der Strahlung seitlich über die Seitenflanken aus dem Halbleiterchip ausgekoppelt wird.

Bei einer vorteilhaften Weiterbildung der Erfindung ist die Vorderseitenkontaktstruktur kammartig mit einer Mehrzahl von Leiterbahnarmen ausgebildet, wobei der Begriff Leiterbahnarme impliziert, dass diese ein Ende aufweisen, das nicht mit weiteren Leiterbahnen der Vorderseitenkontaktstruktur unmittelbar verbunden ist. Besonders bevorzugt weist die Vorderseitenkontaktstruktur einschließlich vier bis einschließlich zehn Leiterbahnarme auf. Dadurch kann eine besonders effiziente und gleichmäßige Stromeinspeisung in den Halbleiterchip erreicht werden. Vorzugsweise verlaufen in einer Reihe angeordnete Leiterbahnarme parallel zueinander. Weiterhin vorzugsweise weisen mehrere in einer Reihe angeordnete Leiterbahnarme untereinander durchweg gleiche Abstände auf.

Bei dem erfindungsgemäßen Verfahren wird die Dünnfilmschicht in Form einer Schichtenfolge epitaktisch auf einem Aufwachssubstrat aufgewachsen. Nachfolgend wird zumindest ein Graben in der Dünnfilmschicht ausgebildet und werden auf der Dünnfilmschicht elektrische Rückseitenkontakte aufgebracht, bevor die Dünnfilmschicht auf einem Trägersubstrat derart aufgebracht wird, dass der Graben dem Trägersubstrat zugewandt ist, und die Dünnfilmschicht mit dem Trägersubstrat verbunden wird. Vor oder nach dem Aufbringen der Dünnfilmschicht auf dem Trägersubstrat wird das Aufwachssubstrat zumindest teilweise entfernt und wird auf der vom Trägersubstrat abgewandten Seite der Dünnfilmstruktur eine elektrische Vorderseitenkontaktstruktur aufgebracht.Schließlich wird der Verbund aus Trägersubstrat und Dünnfilmschicht entlang von Trennungslinien zu Halbleiterchips vereinzelt.

Gemäß einem ersten Verfahren nach der Erfindung wird zumindest ein Graben derart in der Dünnfilmschicht ausgebildet, dass ein einziger Teilbereich außerhalb von Bereichen der Dünnfilmschicht, die mit einer vorgesehenen, nachfolgend noch zu erzeugenden Kontaktstruktur überlappen, definiert wird, und dass der Graben bezüglich einer Haupterstreckungsebene der Dünnfilmschicht schräge Innenwände aufweist. Die elektrischen Rückseitenkontakte werden bevorzugt in dem Teilbereich ausgebildet.

Gemäß einem zweiten Verfahren nach der Erfindung wird zumindest ein Graben in der Dünnfilmschicht derart ausgebildet, dass der Graben auf der Rückseite eine Mehrzahl von Teilbereichen definiert, die außerhalb von Bereichen der Dünnfilmschicht, die mit einer vorgesehenen, nachfolgend noch zu erzeugenden Vorderseitenkontaktstruktur überlappen, liegen und die in Draufsicht auf die Dünnfilmschicht gesehen jeweils zumindest an einer Seite abgesehen von einem eventuell noch dazwischen angeordneten Teil des Grabens direkt benachbart zu einem mit der Vorderseitenkontaktstruktur überlappenden Bereich der Dünnfilmschicht sind.

Die Rückseitenkontakte werden bei beiden Verfahren bevorzugt vor Ausbilden des Grabens in den Bereichen, die für die Teilbereiche oder den Teilbereich vorgesehen sind, ausgebildet. Es versteht sich, dass die Teilbereiche nicht durch den mindestens einen Graben abgegrenzt sein müssen, damit die Rückseitenkontakte in den Teilbereichen oder dem Teilbereich, d.h. in den dafür vorgesehenen Bereiche der Dünnfilmschicht ausgebildet werden können.

Mit besonderem Vorteil wird vor dem Aufbringen der Dünnfilmschicht auf dem Trägersubstrat entlang der Trennungslinien mindestens ein Trennungsgraben gebildet. Dadurch kann bewirkt werden, dass die Seitenflanken der Dünnfilmschicht bei den nachfolgend vereinzelten Halbleiterchips zumindest teilweise schräg sind.

Gemäß einer weiteren Ausführungsform des Verfahrens wird der Graben und/oder der Trennungsgraben mittels Ätzen hergestellt. Bei einem Ätzprozess kann die resultierende Form beziehungsweise der Verlauf der Innenwände der Gräben vorteilhafterweise auf vielfältige Arten durch die Prozessparameter beeinflusst werden.

Weitere vorteilhafte Merkmale und Weiterbildungen, Vorteile und Zweckmäßigkeiten der Erfindung ergeben sich aus den im folgenden in Verbindung mit den Figuren 1 bis 8 beschriebenen Ausführungsbeispielen. Es zeigen:
- Figur 1 eine schematische Zeichnung eines ersten Ausführungsbeispiels des Halbleiterchips in einer Draufsicht;
- Figur 2 eine schematische Zeichnung eines zweiten Ausführungsbeispiels des Halbleiterchips in einer Draufsicht;
- Figur 3 eine schematische Schnittansicht des in Figur 1 dargestellten Halbleiterchips;
- Figur 4 eine schematische Schnittdarstellung der Dünnfilmschicht des Halbleiterchips in einem Stadium des Verfahrens gemäß dem Ausführungsbeispiel;
- Figur 5 eine schematische Schnittdarstellung der Dünnfilmschicht des Halbleiterchips in einem weiteren Stadium des Verfahrens gemäß dem Ausführungsbeispiel;
- Figur 6 eine schematische Zeichnung eines dritten Ausführungsbeispiels des Halbleiterchips in einer Draufsicht auf die Vorderseitenkontaktstruktur;
- Figur 7 eine schematische Zeichnung eines vierten Ausführungsbeispiels des Halbleiterchips in einer Draufsicht auf die Vorderseitenkontaktstruktur;
- Figur 8 eine schematische Zeichnung eines fünften Ausführungsbeispiels des Halbleiterchips in einer Draufsicht auf die Vorderseitenkontaktstruktur;
- Figur 9 eine schematische Zeichnung eines sechsten Ausführungsbeispiels des Halbleiterchips in einer Draufsicht auf die Vorderseitenkontaktstruktur; und
- Figur 10 eine schematische Zeichnung eines siebten Ausführungsbeispiels des Halbleiterchips in einer Draufsicht auf die Vorderseitenkontaktstruktur.

In den Ausführungsbeispielen und Figuren sind gleiche oder gleichwirkende Bestandteile jeweils mit den gleichen Bezugszeichen versehen. Die dargestellten Elemente der Figuren sind nicht als maßstabsgerecht anzusehen, vielmehr können sie zum besseren Verständnis teilweise übertrieben groß und/oder nicht in den tatsächlichen Größenrelationen dargestellt sein.

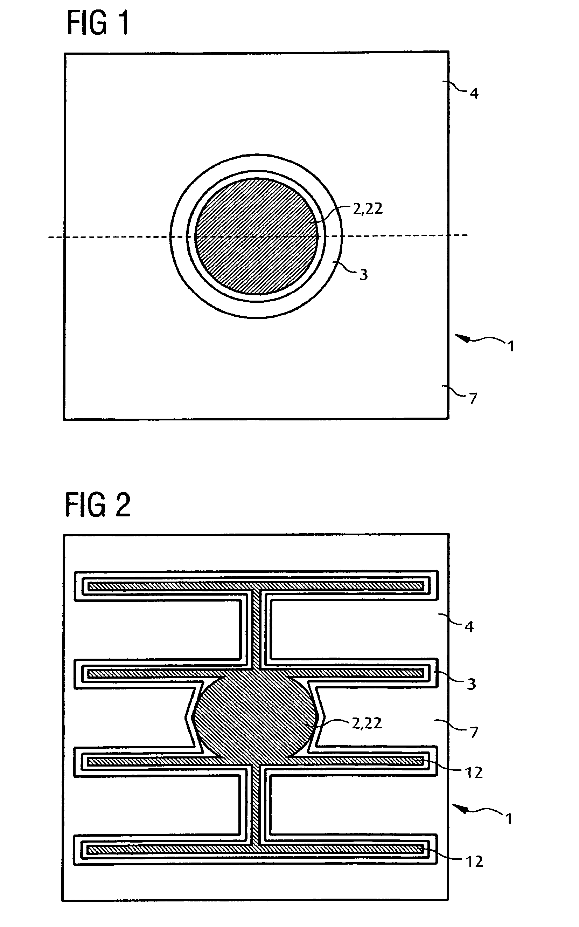

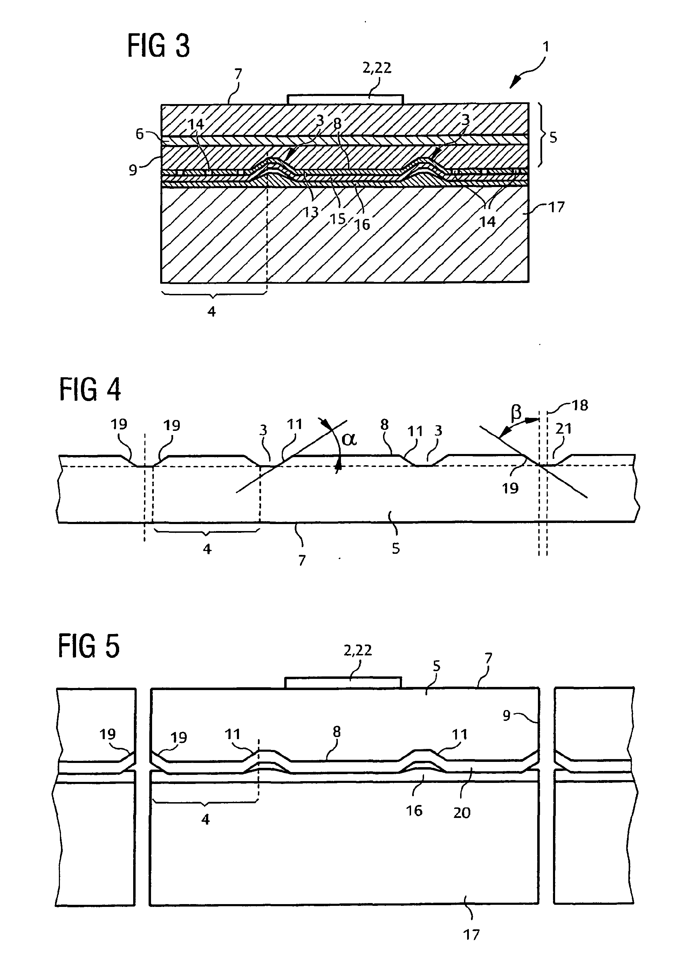

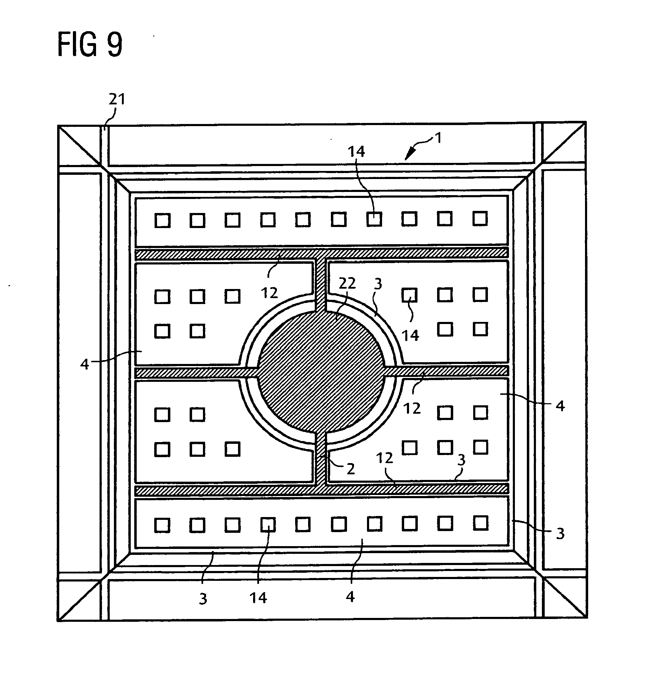

Die Figuren 1, 2 und 6 bis 10 zeigen jeweils einen Halbleiterchip in einer Draufsicht auf eine Vorderseitenkontaktstruktur (2,22), das heißt es ist die Abstrahlseite 7 des Halbleiterchips 1 des jeweiligen Ausführungsbeispiels des Halbleiterchips zu sehen. In diesen Figuren ist jeweils auch mindestens ein Graben 3 angedeutet, obgleich dieser nicht auf der Abstrahlseite 7, sondern auf der Rückseite 8 der Dünnfilmschicht 5 ausgebildet ist (was in der in Figur 3 dargestellten Schnittansicht des Halbleiterchips erkennbar ist) und von daher an sich in den Draufsichten nicht sichtbar wäre. Diese Darstellungsform der Figuren 1, 2 sowie 6 bis 10 soll einer besseren Übersichtlichkeit und einem besseren Verständnis dienen. Auf diese Weise sind in nur einer Figur sowohl die Vorderseitenkontaktstruktur 2 sichtbar als auch ein Verlauf des Grabens 3 erkennbar. In Figur 9 sind zusätzlich zu dem Graben 3 auch lateral Positionen von Rückseitenkontakten 14 angedeutet, die ebenfalls auf der Rückseite der Dünnfilmschicht angeordnet sind.

Bei dem in Figur 1 dargestellten Ausführungsbeispiel weist der Halbleiterchip 1 eine Vorderseitenkontaktstruktur 2 in Form eines kreisrunden Bondpads 22 auf. Auf der Rückseite der Dünnfilmschicht des Halbleiterchips 1 ist ein Graben 3 ausgebildet, der ringförmig um einen Bereich der Dünnfilmschicht verläuft, der gegenüber dem Bondpad 2 liegt, das heißt mit diesem überlappt. Der Graben 3 definiert den Teilbereich 4, indem er diesen in Draufsicht auf den Chip gesehen auf der Rückseite von dem Bereich, der von der Vorderseitenkontaktstruktur 2 überdeckt ist, trennt.

Damit ein derartiger Teilbereich 4 definiert ist, ist es nicht zwingend notwendig, dass der Graben diesen vollständig von dem Bereich unterhalb der Vorderseitenkontaktstruktur abgrenzt. Vielmehr ist es möglich, dass der Graben 3 an einer oder an mehreren Stellen unterbrochen ist. Ebenso ist es möglich, statt eines Grabens 3 eine Vielzahl von nebeneinander ausgebildeten Löchern auszubilden, die gemeinsam den Teilbereich definieren. Derartige Strukturen von Ausnehmungen auf der Rückseite 8 der Dünnfilmschicht 5 sind alternativ zu einem Graben grundsätzlich für eine Umsetzung der Erfindung geeignet und als Analogon zu dem Graben zu verstehen.

Figur 3 zeigt eine Schnittansicht des in Figur 1 dargestellten Halbleiterchips, wobei der Schnitt entlang der in Figur 1 eingezeichneten gestrichelten Linie verläuft. In dieser Darstellung ist erkennbar, dass sich der Graben 3 auf der Rückseite 8 der Dünnfilmschicht 6 befindet. Die Dünnfilmschicht 5 basiert beispielsweise auf einem Phosphit- oder Nitrid-Verbindungs-Halbleitermaterial.

Phosphit-Verbindungs-Halbleitermaterialien sind Verbindungs-Halbleitermaterialien, die Phosphor enthalten, wie z.B. Materialien aus dem System InₓAl_{y}Ga_{1-x-y}P mit 0 ≤ x ≤ 1, 0 ≤ y ≤ 1 und x + y ≤ 1. Analog enthalten Nitrid-Verbindungs-Halbleitermaterialien Stickstoff und umfassen insbesondere Materialien aus dem System InₓAl_{y}Ga_{1-x-y}N mit 0 ≤ x ≤ 1, 0 ≤ y ≤ 1 und x + y ≤ 1. Unter die Gruppe von strahlungsemittierenden Halbleiterchips auf Basis von Nitrid- oder Phosphit-Verbindungs-Halbleitermaterial fallen vorliegende insbesondere solche Halbleiterchips, bei denen die Dünnfilmschicht mindestens eine Einzelschicht enthält, die ein Material aus dem jeweiligen Verbindungs-Halbleitermaterial-System aufweist.

Die Dünnfilmschicht kann beispielsweise einen herkömmlichen pn-Übergang, eine Doppelheterostruktur, eine Einfachquantentopfstruktur (SQW-Struktur) oder eine Mehrfachquantentopfstruktur (MQW-Struktur) aufweisen, durch die eine elektromagnetische strahlungsemittierende Zone 6 ausgebildet ist. Solche Strukturen sind dem Fachmann bekannt und werden von daher an dieser Stelle nicht näher erläutert. Beispiele für solche MQW-Strukturen sind in den Druckschriften WO 01/39282, WO 98/31055, US 5831277, EP 1 017 113 und US 5684309 beschrieben, deren Offenbarungsgehalt insofern hiermit durch Rückbezug aufgenommen wird.

Auf der Rückseite der Dünnfilmschicht 5 ist eine dielektrische Schicht 13 ausgebildet, die im Teilbereich 4 Löcher aufweist, in denen elektrische Rückseitenkontakte 14 in Form von Durchkontaktierungen ausgebildet sind. Auf der dielektrischen Schicht 13 ist eine elektrisch leitfähige Schicht 15 ausgebildet, die für die elektromagnetische Strahlung reflektierend ist. Diese kann z.B. ein geeignetes Metall wie beispielsweise Silber oder Gold aufweisen.

Die Dünnfilmschicht 5 ist mittels einer Lotschicht 16 mit einem Trägersubstrat 17 verbunden. Das Trägersubstrat besteht z.B. im Wesentlichen aus SiC, GaAs oder Ge. Statt einer Lotschicht kann hierfür beispielsweise auch ein elektrisch leitfähiger Klebstoff verwendet werden. Im Falle eines nicht elektrisch leitfähigen Trägersubstrates 17 ist für diesen Zweck auch ein elektrisch isolierendes Material geeignet.

Bei dem Verfahren zum Herstellen des Halbleiterchips wird die Dünnfilmschicht 5 auf einem Aufwachssubstrat aufgewachsen. Nachfolgend wird dieses Aufwachssubstrat zumindest teilweise von der Dünnfilmschicht entfernt und wird die Dünnfilmschicht auf ein Trägersubstrat aufgebracht. Dabei kann das Entfernen des Aufwachssubstrates sowohl nach als auch vor dem Aufbringen der Dünnfilmschicht auf dem Trägersubstrat erfolgen. Diese Verfahrensschritte erfolgen bevorzugt nach der Ausbildung der Gräben.

Nach dem Ausbilden der Dünnfilmschicht wird in die Rückseite 8 von dieser mindestens ein Graben 3 ausgebildet was in Figur 4 dargestellt ist. Dies kann z.B. mittels Ausbilden einer Ätzmaske, z.B. durch Photolithographie, und Ätzen mit einem für das jeweilige Ätzmaterial geeigneten Ätzmittel erfolgen. Die hierfür nötigen Maßnahmen und geeigneten Materialien sind dem Fachmann allgemein bekannt und werden von daher an dieser Stelle nicht weitergehend erläutert.

Der Graben weist beispielsweise eine Tiefe von etwa 2 µm auf und hat Innenwände 11, deren Haupterstreckungsebenen um einen Winkel α gegenüber einer Haupterstreckungsebene der Dünnfilmschicht 5 geneigt ist (siehe Figur 4). Der Winkel α beträgt beispielsweise 30°.

Die Tiefe der Gräben 3 ist kleiner als die halbe Dicke der Dünnfilmschicht 5 und so gering, dass die Gräben 3 die strahlungsemittierende Zone 6 der Dünnfilmschicht nicht beschädigen oder durchtrennen.

Bei dem in Figur 4 dargestellten Ausführungsbeispiel werden zusätzlich zu den Gräben 3 noch Trennungsgräben 21 entlang von Trennungslinien 18 ausgebildet. Diese können beispielsweise wie die Gräben 3 ausgebildet werden, so dass die Innenwände der Trennungsgräben 21 nach dem Vereinzeln der Dünnfilmschicht 5 und dem Trägersubstrat 17 schräge Flankenbereiche 19 der Dünnfilmschicht 5 bilden, deren Haupterstreckungsebenen um einen Abschrägwinkel β zur Senkrechten der Haupterstreckungsebene der Dünnfilmschicht 5 geneigt sind. Der Abschrägwinkel β ist in Figur 4 eingezeichnet und beträgt beispielsweise 60°.

Die Innenwände 11, 19 der Gräben 3 und der Trennungsgräben 21 sind in der Regel nicht eben ausgebildet, sondern können z.B. eine konkave oder konvexe Form aufweisen.

Nach dem Ausbilden der Gräben 3 und Trennungsgräben 21 wird auf der Rückseite 8 der Dünnfilmschicht 5 eine Kontakt- und Spiegelschicht 20 ausgebildet. Diese kann wie bei dem anhand von Figur 3 erläuterten Ausführungsbeispiel eine dielektrische Schicht 13 mit elektrischen Rückseitenkontakten 14 in Form von Durchkontaktierungen sowie eine elektromagnetische Strahlung reflektierende Schicht 15 umfassen. Alternativ ist es beispielsweise aber auch möglich, dass die Kontakt- und Spiegelschicht 20 eine strahlungsdurchlässige und elektrisch leitfähige Kontaktschicht und eine auf dieser aufgebrachte elektrisch leitfähige Spiegelschicht umfasst (nicht dargesstellt). Die Kontaktschicht weist beispielsweise ZnO auf.

Die transparente Kontaktschicht dient als Rückseitenkontakt und wird nur in dem Teilbereich bzw. den Teilbereichen 4 auf die Dünnfilmschicht 5 aufgebracht, damit nur in diesen Bereichen der Rückseite 8 eine Stromeinspeisung in die Dünnfilmschicht 5 erfolgen kann. Dadurch, dass der Rückseitenkontakt lediglich in den Teilbereichen ausgebildet wird, wird bei den Halbleiterchips 1 in einen Bereich zwischen der Vorderseitenkontaktstruktur 2 und der Rückseite 8 keine oder nur relativ wenig elektromagnetische Strahlung erzeugt. Mittels dieser Maßnahme kann größtenteils verhindert werden, dass elektromagnetische Strahlung von der Vorderseitenkontaktstruktur absorbiert wird, was die Effizienz der Halbleiterchips steigert.

Zusätzlich wird elektromagnetische Strahlung, die in einem Bereich der Dünnfilmschicht 5 zwischen dem Teilbereich 4 und der Abstrahlseite 7 erzeugt wird, zumindest teilweise durch die Gräben 3 daran gehindert, in den Bereich unterhalb der Vorderseitenkontaktstruktur 2 zu gelangen. An den zu dem Teilbereich 4 gewandten Innenwänden 11 der Gräben 3 wird die darauf auftreffende elektromagnetische Strahlung von dem Bereich unter der Vorderseitenkontaktstruktur wegreflektiert und zu einem Bereich der Abstrahlseite 7 hinreflektiert, in dem sie aus dem Halbleiterchip 1 ausgekoppelt werden kann.

Entsprechend sorgen die schrägen Flankenbereiche 19 dafür, dass elektromagnetische Strahlung, die ohne die schrägen Flankenbereiche 19 über die Seitenflanken 9 aus dem Halbleiterchip 1 ausgekoppelt würde, von den Seitenflanken 9 weg und in Richtung Abstrahlseite 7 reflektiert wird. Auch dadurch wird die Effizienz des Halbleiterchips 1 verbessert.

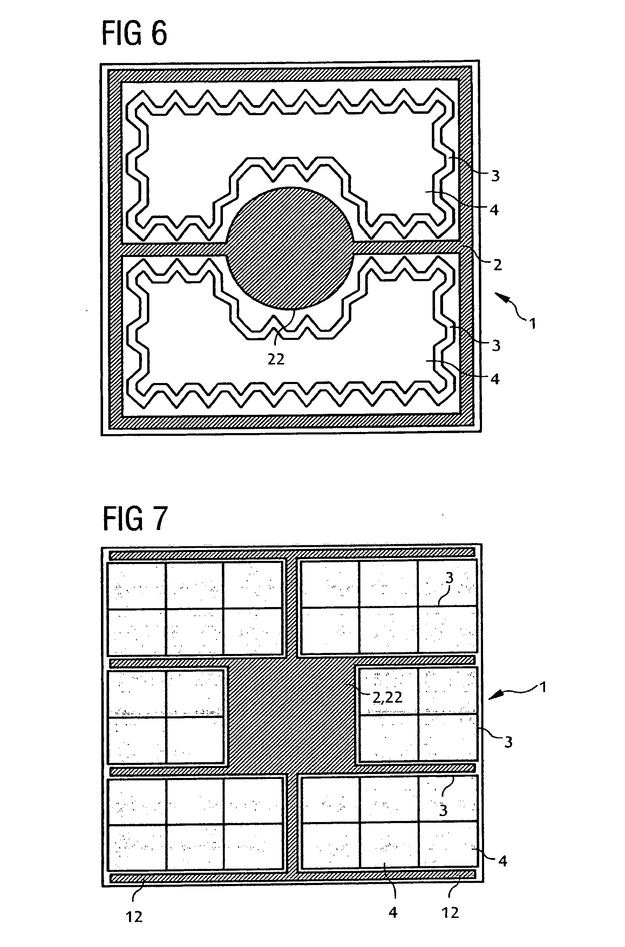

In Figur 6 ist ein weiteres Ausführungsbeispiel des Halbleiterchips 1 dargestellt. Bei diesem umfasst die Vorderseitenkontaktstruktur 2 nicht nur ein Bondpad 22, sondern zudem einen entlang des Randes des Halbleiterchips 1 verlaufenden Leiterbahnrahmen sowie zwei Leiterbahnstücke, die das Bondpad 22 mit dem Leiterbahnrahmen elektrisch leitend verbinden. Dadurch weist dieser Halbleiterchip auf der Rückseite der Dünnfilmschicht 5 zwei voneinander getrennte Bereiche außerhalb von Bereichen gegenüber der Vorderseitenkontaktstruktur auf. In diesen Bereichen ist jeweils ein Graben 3 ausgebildet, der in einer geschlossenen Bahn entlang der Ränder der Bereiche gegenüber der Vorderseitenkontaktstruktur verläuft. Diese zwei Gräben 3 definieren zwei Teilbereiche 4.

Im Unterschied zu den in den Figuren 1 und 2 dargestellten Gräben 3 verlaufen die Gräben 3 bei dem Halbleiterchip gemäß Figur 6 in einer gezackten Bahn. Dadurch weisen die Innenwände der Gräben 3 eine Vielzahl unterschiedlicher Orientierungen auf, wodurch mehrfache interne Reflexion von elektromagnetischer Strahlung weiter vermindert und eine Strahlungsauskopplung verbessert werden kann.

Bei dem in Figur 2 dargestellten Ausführungsbeispiel des Halbleiterchips 1 umfasst die Vorderseitenkontaktstruktur 2 neben einem Bondpad 22 acht Leiterbahnarme 12, von denen vier von dem Bondpad ausgehen und die übrigen vier durch insgesamt zwei Leiterbahnstücke mit dem Bondpad verbunden sind. Die Leiterbahnarme 12 verlaufen im wesentlichen parallel zueinander, so dass die Vorderseitenkontaktstruktur 2 kammartig ausgebildet ist.

Anders ausgedrückt weist die in Figur 2 dargestellte Vorderseitenkontaktstruktur 2 vier separate Leiterbahngeraden auf, die sich nicht schneiden und von denen die mittleren zwei durch ein Bondpad 22 elektrisch leitend verbunden sind und die äußeren zwei Leiterbahngeraden durch zwei Leiterbahnstücke elektrisch leitend mit dem Bondpad 2 und somit auch mit den mittleren zwei Leiterbahngeraden verbunden sind. Alternativ könnten die äußeren zwei Leiterbahnstücke auch statt mit dem Bondpad 22 mit den inneren Leiterbahngeraden elektrisch leitend verbunden sein.

Die Leiterbahnarme bzw. die Leiterbahngeraden weisen ungefähr einen gleichgroßen Abstand zu benachbarten Leiterbahnarmen bzw. Leiterbahngeraden auf und sind weitestgehend gleichmäßig über die Fläche der Abstrahlseite 7 des Halbleiterchips 1 verteilt. Der Abstand zwischen den Leiterbahngeraden ist kleiner als oder gleich 100 µm und beträgt z.B. 80 µm. Dadurch wird eine sehr gleichmäßige Stromeinspeisung über die gesamte Abstrahlseite der Dünnfilmschicht 5 ermöglicht.

Der Graben 3 ist bei dem in Figur 2 dargestellten Ausführungsbeispiel auf der Rückseite der Dünnfilmschicht 5 in einer geschlossenen Bahn entlang dem Rand der Bereiche ausgebildet, die mit der Vorderseitenkontaktstruktur 2 überlappen. Dadurch wird wie bei dem Ausführungsbeispiel gemäß Figur 1 ebenfalls ein einziger Teilbereich 4 gebildet, wobei jedoch aufgrund der kammartigen Vorderseitenkontaktstruktur 2 eine verbesserte Stromeinspeisung in dem Bereich zwischen dem Teilbereich und der Abstrahlseite 7 bewirkt ist.

Der in Figur 7 dargestellte Halbleiterchip 1 weist ebenfalls eine kammartige Vorderseitenkontaktstruktur 2 mit acht Leiterbahnarmen 12 bzw. vier Leiterbahngeraden auf. Die äußeren Leiterbahngeraden verlaufen hier entlang des Randes des Halbleiterchips 1, so dass sich zwischen den äußeren Leiterbahngeraden und dem Rand des Halbleiterchips kein Teilbereich oder Teil eines Teilbereichs befindet, das heißt zwischen den äußeren Leiterbahngeraden und dem jeweils benachbarten Rand des Halbleiterchips verläuft auch kein Graben auf der Rückseite der Dünnfilmschicht 5.

Der in Figur 7 dargestellte Halbleiterchip weist eine Vielzahl von Gräben 3 auf, die im Unterschied zu den Figuren 1, 2 und 6 durch einfache Linien symbolisiert sind. Die Gräben 3 verlaufen nicht nur entlang dem Rand von Bereichen, die mit der Vorderseitenkontaktstruktur 2 überlappen, sondern es gibt Gräben, die zusätzlich im wesentlichen von den Rändern der Bereiche gegenüber der Vorderseitenkontaktstruktur wegverlaufen, insbesondere im Wesentlichen senkrecht von diesen wegverlaufen. Dadurch werden zwischen jeweils zwei benachbarten Leiterbahnarmen 12 sechs bzw. vier Teilbereiche definiert, die in diesem Ausführungsbeispiel auf der Rückseite eine pyramidenstumpfartige Form aufweisen. Insgesamt weist der Halbleiterchip 1 32 Teilbereiche 4 auf, wobei jeder Teilbereich 4 zumindest zu einem Bereich gegenüber der Vorderseitenkontaktstruktur direkt benachbart ist. Dadurch wird eine möglichst gute Stromeinspeisung in die aktive Zone zwischen dem Teilbereich und der Abstrahlseite 7 bewirkt.

Jeder dieser Teilbereiche weist beispielsweise eine Fläche von (37 x 37) µm² auf. In einem alternativen Ausführungsbeispiel kann diese Fläche mehr als (40 x 40) µm², beispielsweise (42 x 42) µm² betragen.

Durch die Ausbildung mehrerer Teilbereiche werden vorteilhafterweise auch mehrere Gräben mit Innenwänden ausgebildet, an denen die elektromagnetische Strahlung im wesentlichen derart in Richtung der Abstrahlseite 7 reflektiert bzw. umgelenkt wird, dass sie an der Abstrahlseite aus dem Halbleiterchip ausgekoppelt wird. Die Anzahl der Teilbereiche bzw. der Gräben darf jedoch nicht zu groß werden, da sonst der elektrische Strom auf der Rückseite auf einer zu geringen Fläche in den Halbleiterchip eingespeist wird. Dies könnte sich nachteilig auf die Strombelastbarkeit des Halbleiterchips auswirken.

Mit einem Halbleiterchip, dessen Vorderseitenkontaktstruktur und dessen Teilbereiche entsprechend dem in Figur 7 dargestellten Ausführungsbeispiel ausgebildet worden sind, konnte eine sehr hohe Effizienz erzielt werden. Bei einem Strom von 20 mA konnte in diesem Fall eine Strahlungsleistung von etwa 96 lm/W erzielt werden, wobei die Strahlungsintensität bei einer Wellenlänge von 610 nm gemessen wurde. Schätzungsweise ist es mit einem Halbleiterchip gemäß der Erfindung möglich, eine Strahlungsleistung von 80 lm/W reproduzierbar zu erreichen.

Um eine möglichst gute Auskopplung der elektromagnetischen Strahlung aus dem Halbleiterchip zu bewirken, wird die Abstrahlseite 7 der Dünnfilmschicht 6 beispielsweise mit einer Strukturierung versehen bzw. aufgerauht. Geeignete Aufrauhungsstrukturen sowie Verfahren zu deren Herstellung sind z.B. in den deutschen Patentanmeldungen 10229231 und 10064448 beschrieben.

Zusätzlich zu der Abstrahlseite kann auch die gesamte freie Oberfläche der Dünnfilmschicht aufgerauht werden.

Beispielsweise wird die Dünnfilmschicht in einem Plasmareaktor aufgerauht, wobei wenigstens ein Maskengas eingeleitet wird, das auf einer Oberfläche der Dünnfilmschicht eine Maskenschicht im Zustand des Inselwachstums bildet und mindestens ein die Oberfläche der Dünnfilmschicht ätzendes Gas oder Gasgemisch in den Plasmareaktor eingeleitet wird. Als Maskengas kann ein Polymerbildendes Gas verwendet werden, das z.B. wenigstens ein Element der Gruppe SF₆, CF₄, CHF₃, BF₃ und BCl₃ enthält. Das Ätzgas enthält z.B. Sauerstoff und/oder Chlorgas.

Alternativ oder zusätzlich kann ein Verfahren zum Aufrauhen verwendet werden, bei dem auf eine zu strukturierende Materialschicht der Dünnfilmschicht ein Maskenmaterial aufgebracht wird, dessen Benetzungseigenschaften derart gewählt sind, dass es auf der zu strukturierenden Materialschicht eine Strukurierungsschicht ausbildet. Die Strukturierungsmaske weist z.B. eine Vielzahl von voneinander getrennten oder wenigstens teilweise miteinander vernetzen Inseln auf. Die zu stukturierende Materialschicht wird mittels eines materialabtragenden Prozessschrittes strukturiert.

Das Strukturieren der zu strukturierenden Materialschicht erfolgt beispielsweise zumindest zum Teil mittels eines Barrel-Ätzverfahrens, eines Plasmaätzverfahrens, eines reaktiven Ionenätzverfahrens oder eines reaktiven Ionenstrahlätzverfahrens. Das Maskenmaterial weist z.B. ein metallisches Material wir Ag auf.

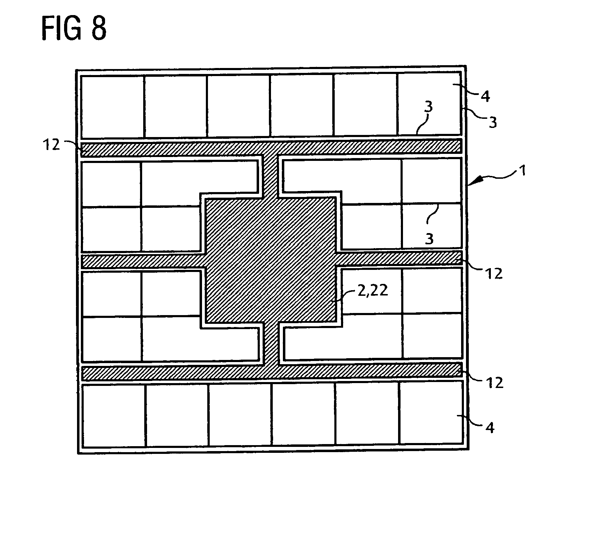

Bei dem in Figur 8 dargestellten Ausführungsbeispiel des Halbleiterchips weist die Vorderseitenkontaktstruktur im Unterschied zu der in Figur 7 dargestellten Vorderseitenkontaktstruktur lediglich sechs Leiterbahnarme 12 auf. Auch bei diesem Ausführungsbeispiel definieren die Gräben 3 eine Mehrzahl von Teilbereichen 4, wobei auch zwischen den äußeren Leiterbahnarmen 12 und den zu diesen benachbarten Chiprand Teilbereiche 4 definiert bzw. Gräben 3 ausgebildet sind. Auch mit einer derartigen Vorderseitenkontaktstruktur ist eine möglichst gleichmäßige Bestromung der Bereiche der strahlungsemittierenden Zone möglich, die zwischen den Teilbereichen und der Abstrahlseite liegen.

Der in Figur 9 dargestellte Halbleiterchip 1 ähnelt dem vorhergehend anhand Figur 8 erläuterten Halbleiterchip. Die Vorderseitenkontaktstruktur 2 weist ein rundes Bondpad 22 und sechs Leiterbahnarme 12 auf, von denen zwei von dem Bondpad ausgehen und die übrigen vier durch insgesamt zwei Leiterbahnstücke mit dem Bondpad verbunden sind. Die Leiterbahnarme 12 verlaufen im wesentlichen parallel zueinander, so dass die Vorderseitenkontaktstruktur kammartig ausgebildet ist.

Das Bondpad 22 ist im wesentlichen in der Mitte der Vorderseite des Halbleiterchips 1 angeordnet. Alternativ ist es bei allen erläuterten Ausführungsbeispielen auch möglich, das Bondpad 22 versetzt auf der Vorderseite des Halbleiterchips 1, insbesondere auch am Rand des Halbleiterchips 1 anzuordnen.

Ist das Bondpad 22 am Rand des Halbleiterchips 1 angeordnet, so kann es zum Beispiel vorteilhaft sein, dass die Leiterbahnarme 12 nur noch auf einer Seite von dem Bondpad 22 und/oder von mit dem Bondpad verbundenen Leiterbahnstücken ausgehen, so dass zum Beispiel aus einer Vorderseitenkontaktstruktur 2 mit sechs Leiterbahnarmen eine mit lediglich drei Leiterbahnarmen wird. Dabei handelt es sich weiterhin um separate Leiterbahngeraden, die sich nicht schneiden und die durch einen Bondpad 22 und/oder durch Leiterbahnstücke elektrisch leitend miteinander verbunden sind, wobei diese Verbindung anstatt in einem mittleren Bereich der Vorderseite des Halbleiterchips 1 an dessen Rand ausgebildet ist.

Allgemein ausgedrückt weist die Vorderseitenkontaktstruktur 2 einschließlich vier bis einschließlich zehn Leiterbahnarme und/oder einschließlich zwei bis einschließlich fünf Leiterbahngeraden auf.

Bei dem in Figur 9 dargestellten Halbleiterchip 1 definiert der Graben 3, der auf der Rückseite der Dünnfilmschicht im wesentlichen entlag der Ränder der Vorderseitenkontaktstruktur 2 und des Halbleiterchips 1 verläuft, insgesamt sechs Teilbereiche 4. Die Teilbereiche 4 sind zusätzlich auch durch die Vorderseitenkontaktstruktur 2 lateral voneinander getrennt.

Jedem Teilbereich 4 kann ein einziger oder eine Mehrzahl von Rückseitenkontakten 14 zugeordnet sein. Bei dem in Figur 9 dargestellten Halbleiterchip ist jedem Teilbereich 4 eine Mehrzahl von Rückseitenkontakten 14 zugeordnet, das heißt die Rückseite der Dünnfilmschicht weist in jedem Teilbereich 4 mehrere voneinander getrennte Teilflächen auf, an denen die Dünnfilmschicht mittels elektrischem Kontaktmaterials elektrisch leitend kontaktiert ist.

Alternativ können diese separaten Teilflächen bzw. die Rückseitenkontakte teilweise oder vollständig miteinander verbunden sein.

Die vier mittleren Teilbereiche 4 weisen bei dem in Figur 9 dargestellten Halbleiterchip 1 jeweils fünf Rückseitenkontakte 14 auf, während die äußeren zwei der Teilbereiche 4, die sich streifenartig entlang einer Kante des Halbleiterchips 1 erstrecken, jeweils zehn Rückseitenkontakte 14 aufweisen.

Allgemein kann jeder Teilbereich 4 zweckmäßigerweise zwischen einschließlich zwei und einschließlich 20 Rückseitenkontakten aufweisen. Bevorzugt sind jedem Teilbereich 4 zwischen einschließlich drei und einschließlich zehn Rückseitenkontakte 14 zugeordnet. Besonders bevorzugt umfasst jeder Teilbereich 4 zwischen einschließlich fünf und einschließlich zehn Rückseitenkontakte.

Der Halbleiterchip 1 hat beispielsweise eine Chipkantenlänge von kleiner als oder gleich 400 µm, bevorzugt von kleiner als oder gleich 300 µm. Für derartig kleine Halbleiterchips sind insbesondere die in den Figuren 1, 2 und 5 bis 9 dargestellten Vorderseitenkontaktstrukturen 2 und/oder die Aufteilung der Teilbereiche 4 dieser Halbleiterchips 1 geeignet.

Wie vorhergehend bereits erläutert lässt sich ein Halbleiterchip gemäß der Erfindung vorteilhafterweise jedoch auch insbesondere zu größeren Abmessungen hin skalieren. So kann der Chip mit Vorteil auch eine Chipkantenlänge von größer als oder gleich 1000 µm aufweisen.

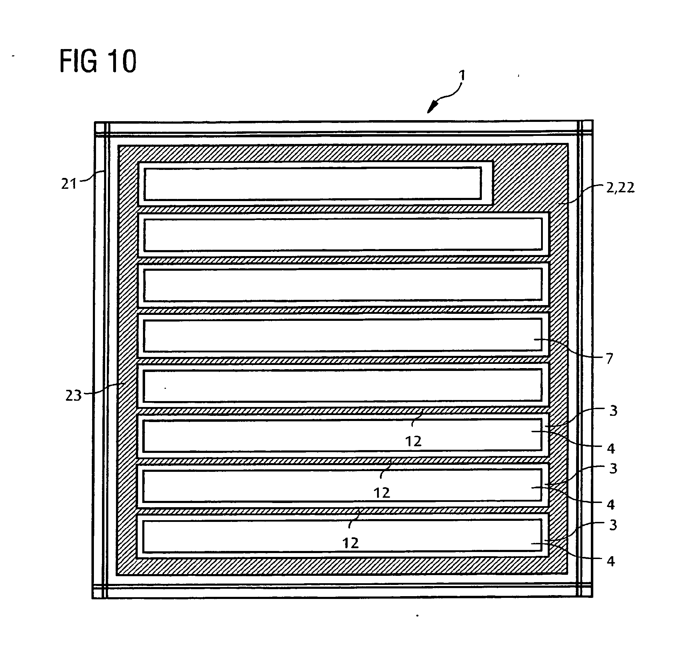

Bei Halbleiterchips 1 mit besonders großen Abmessungen kann eine Vorderseitenkontaktstruktur 2 und/oder Aufteilung der Teilbereiche 4 derart wie bei dem in Figur 10 dargestellten Halbleiterchip 1 von Vorteil sein. Die Teilbereiche 4 weisen eine streifenartige Form auf und sind im wesentlichen parallel zueinander angeordnet. Das Bondpad 2 ist am Rand des Halbleiterchips angeordnet. Es befindet sich in diesem Beispiel in einer Ecke des Halbleiterchips, wobei die Vorderseite der Dünnfilmschicht nicht nur vier, sondern eine beliebige Anzahl von Ecken aufweisen kann. Die Vorderseitenkontaktstruktur 2 weist zudem eine Mehrzahl von Leiterbahnarmen 12 auf, die im wesentlichen entlang der streifenartigen Teilbereiche 4 verlaufen. Die Leiterbahnarme 12 sind derart angeordnet, dass jeder Teilbereich 4 auf beiden Längsseiten lateral an einen Leiterbahnarm 12 grenzt.

Die Leiterbahnarme 12 sind durch ein vom Bondpad 22 ausgehendes Leiterbahnstück mit dem Bondpad 22 verbunden oder sie erstrecken sich unmittelbar vom Bondpad weg. Das Leiterbahnstück erstreckt sich entlang einer ersten Seitenkante des Halbleiterchips 1. Zusätzlich oder alternativ weist die Vorderseitenkontaktstruktur 2 auf einer der ersten Seitenkante gegenüber liegenden Seitenkante des Halbleiterchips 1 ein Leiterbahnstück auf, das die Leiterbahnarme 12 miteinander elektrisch leitend verbindet und sich im wesentlichen senkrecht zu den Leiterbahnarmen 12 erstreckt.

Wenn beide Leiterbahnstücke in der Vorderseitenkontaktstruktur 2 enthalten sind, dann weist diese eine gitterartige Form auf. Die Teilbereiche 4 sind lateral gesehen innerhalb der Freiräume einer solchen gitterartigen Vorderseitenkontaktstruktur 2 angeordnet. Ein Vorteil der gitterartigen Vorderseitenkontaktstruktur ist, dass diese an einer Stelle unterbrochen sein kann, ohne dass verschiedene ihrer Teile notwendigerweise elektrisch voneinander getrennt werden. Somit kann eine Empfindlichkeit gegenüber Beschädigungen der Vorderseitenkontaktstruktur bei Halbleiterchips signifikant verringert werden. Dies ist insbesondere bei Vorderseitenkontaktstrukturen mit relativ schmalen und langen Kontaktbahnen von Vorteil.

In der WO 02/13281 sind weitergehende Details hinsichtlich geeigneter Materialien für die Dünnfilmschicht, die elektrischen Kontakte und reflektierenden Schichten sowie für Dotierstoffkonzentrationen und Verfahrensschritte wie dem Vereinzeln des Verbundes aus Dünnfilmschicht und Trägersubstrat offenbart.

Durch die Erfindung ist es entweder möglich, Halbleiterchips herzustellen, die bezüglich Halbleiterchips gemäß dem Stand der Technik etwa gleich groß sind und dabei eine bessere Effizienz und größere Strahlungsleistung aufweisen. Alternativ ist es auch möglich, Halbleiterchips mit einer etwa gleich großen Strahlungsleistung herzustellen, die jedoch aufgrund einer höheren Effizienz eine geringere Größe als herkömmliche Halbleiterchips aufweisen, d.h. mittels der Erfindung können herkömmliche Halbleiterchips ohne Einbuße hinsichtlich ihrer Strahlungsleistung miniaturisiert werden.

Der Halbleiterchip ist insbesondere eine Dünnfilm-Leuchtdiodenchip, der sich insbesondere durch folgende charakteristische Merkmale auszeichnet:
- an einer zu einem Trägerelement hin gewandten ersten Hauptfläche einer strahlungserzeugenden Epitaxieschichtenfolge bzw. Dünnfilmschicht ist eine reflektierende Schicht aufgebracht oder ausgebildet, die zumindest einen Teil der in der Epitaxieschichtenfolge erzeugten elektromagnetischen Strahlung in diese zurückreflektiert;
- die Epitaxieschichtenfolge weist eine Dicke im Bereich von 20 µm oder weniger, insbesondere im Bereich von 10 µm auf; und
- die Epitaxieschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der epitaktischen Epitaxieschichtenfolge führt, d.h. sie weist ein möglichst ergodisch stochastisches Streuverhalten auf.

Ein Grundprinzip eines Dünnschicht-Leuchtdiodenchips ist beispielsweise in I. Schnitzer et al., Appl. Phys. Lett. 63 (16), 18. Oktober 1993, 2174 - 2176 beschrieben.

Der Schutzumfang der Erfindung ist nicht durch die Beschreibung der Erfindung anhand der Ausführungsbeispiele beschränkt. Die Erfindung ist in den Ansprüchen 1 und 15 definiert.

## Patentansprüche

1. Halbleiterchip für die Optoelektronik mit
- einer Dünnfilmschicht, in der eine elektromagnetische Strahlung emittierende Zone ausgebildet ist und die eine Abstrahlseite, eine Rückseite und Seitenflanken aufweist, die die Rückseite mit der Abstrahlseite verbinden, und
- einem Träger für die Dünnfilmschicht, der an der Rückseite angeordnet und mit dieser verbunden ist,
wobei auf der Abstrahlseite mindestens eine elektrische Vorderseitenkontaktstruktur und auf der Rückseite mindestens ein Graben ausgebildet ist, wobei
- der Graben an der Rückseite einen einzigen Teilbereich der Dünnfilmschicht definiert, der nicht mit der Vorderseitenkontaktstruktur überlappt oder der Graben auf der Rückseite eine Mehrzahl von Teilbereichen definiert, die nicht mit der Vorderseitenkontaktstruktur überlappen und die jeweils zu mindestens einem mit der Vorderseitenkontaktstruktur überlappenden Bereich benachbart sind,
- auf der Rückseite nur in dem Teilbereich beziehungsweise in den Teilbereichen elektrische Rückseitenkontakte ausgebildet sind,
- der Graben bezüglich einer Haupterstreckungsebene der Dünnfilmschicht schräge Innenwände zur Umlenkung der elektromagnetischen Strahlung aufweist, und
- sich der Graben mit zunehmender Tiefe verjüngt und die Innenwände des Grabens Haupterstreckungsebenen aufweisen, die mit einer Haupterstreckungsebene der Dünnfilmschicht einen Neigungswinkel von kleiner als oder gleich 45° einschließen.

2. Halbleiterchip nach Anspruch 1,
**dadurch gekennzeichnet, dass**
jeder Teilbereich der Mehrzahl von Teilbereichen eine Fläche von größer als oder gleich (35 x 35) µm² bedeckt.

3. Halbleiterchip nach Anspruch 2,
**dadurch gekennzeichnet, dass**
dass jeder Teilbereich eine Fläche von größer als oder gleich (40 x 40) µm² bedeckt.

4. Halbleiterchip nach einem der vorhergehenden Ansprüche,
**dadurch gekennzeichnet, dass**
der Graben eine Tiefe aufweist, die kleiner als eine halbe Dicke der Dünnfilmschicht ist.

5. Halbleiterchip nach einem der vorhergehenden Ansprüche,
**dadurch gekennzeichnet, dass**
der Graben zwischen einschließlich 0,5 und einschließlich 3 µm tief ist.

6. Halbleiterchip nach einem der vorhergehenden Ansprüche,
**dadurch gekennzeichnet, dass**
der Neigungswinkel zwischen einschließlich 15° und einschließlich 35° beträgt.

7. Halbleiterchip nach einem der vorhergehenden Ansprüche,
**dadurch gekennzeichnet, dass**
die Seitenflanken zumindest in einem an die Rückseite angrenzenden Flankenbereich bezüglich einer Haupterstreckungsebene der Dünnfilmschicht schräg verlaufen.

8. Halbleiterchip nach Anspruch 7,
**dadurch gekennzeichnet, dass**
Haupterstreckungsebenen der schräg verlaufenden Teile der Seitenflanken um einen Abschrägwinkel von größer als oder gleich 45° zur Senkrechten der Haupterstreckungsebene der Dünnfilmschicht geneigt sind.

9. Halbleiterchip nach einem der vorhergehenden Ansprüche,
**dadurch gekennzeichnet, dass**
die Vorderseitenkontaktstruktur kammartig mit einer Mehrzahl von Leiterbahnarmen ausgebildet ist.

10. Halbleiterchip nach Anspruch 9,
**dadurch gekennzeichnet, dass**
die Vorderseitenkontaktstruktur einschließlich 4 bis einschließlich 10 Leiterbahnarme aufweist.

11. Halbleiterchip nach einem der vorhergehenden Ansprüche,
**dadurch gekennzeichnet, dass**
die elektromagnetische Strahlung emittierende Zone einteilig ausgebildet ist.

12. Halbleiterchip nach einem der vorhergehenden Ansprüche,
**dadurch gekennzeichnet, dass**
die freie Oberfläche der Dünnfilmschicht teilweise oder vollständig aufgerauht ist.

13. Halbleiterchip nach einem der vorhergehenden Ansprüche,
**dadurch gekennzeichnet, dass**
der Graben den Teilbereich in einer Haupterstreckungsebene der Rückseite von den Bereichen, die gegenüber der Vorderseitenkontaktstruktur liegen, trennt.

14. Halbleiterchip nach einem der vorhergehenden Ansprüche,
**dadurch gekennzeichnet, dass**
der Graben entlang von Rändern der Bereiche, die gegenüber der Vorderseitenkontaktstruktur liegen, verläuft.

15. Verfahren zum gleichzeitigen Herstellen einer Mehrzahl von Halbleiterchips für die Optoelektronik mit einer Dünnfilmschicht, in der eine elektromagnetische Strahlung emittierende Zone ausgebildet ist, mit den Verfahrensschritten:
- Ausbilden einer Dünnfilmschicht durch epitaktisches Aufwachsen einer Schichtenfolge, welche die elektromagnetische Strahlung emittierende Zone enthält, auf einem Aufwachssubstrat;
- Ausbilden von zumindest einem Graben in der Dünnfilmschicht, wobei sich der Graben mit zunehmender Tiefe verjüngt und die Innenwände des Grabens Haupterstreckungsebenen aufweisen, die mit einer Haupterstreckungsebene der Dünnfilmschicht einen Neigungswinkel von kleiner als oder gleich 45° einschließen, derart, dass ein einziger Teilbereich außerhalb von Bereichen gegenüber einer zu erzeugenden Kontaktstruktur definiert wird und dass der Graben bezüglich einer Haupterstreckungsebene der Dünnfilmschicht schräge Innenwände aufweist oder derart, dass der Graben auf der Rückseite eine Mehrzahl von Teilbereichen definiert, die außerhalb von Bereichen gegenüber einer zu erzeugenden Vorderseitenkontaktstruktur liegen und die jeweils zu mindestens einem dieser Bereiche oder einem mit diesen Bereichen überlappenden Bereich direkt benachbart sind, und dass der Graben bezüglich einer Haupterstreckungsebene der Dünnfilmschicht schräge Innenwände aufweist;
- Ausbilden von elektrischen Rückseitenkontakten in dem Teilbereich;
- Aufbringen der Dünnfilmschicht auf einem Trägersubstrat derart, dass der Graben zum Trägersubstrat gewandt ist, und Verbinden der Dünnfilmschicht mit dem Trägersubstrat;
- zumindest teilweises Entfernen des Aufwachssubstrates;
- Ausbilden einer elektrischen Vorderseitenkontaktstruktur auf der der Ausnehmung gegenüberliegenden Seite der Dünnfilmschicht; und
- Vereinzeln des Verbundes aus Trägersubstrat und Dünnfilmschicht entlang von Trennungslinien zu Halbleiterchips.

16. Verfahren nach Anspruch 15,
**dadurch gekennzeichnet, dass**
vor dem Aufbringen der Dünnfilmschicht auf dem Trägersubstrat auf der Rückseite entlang der Trennungslinien mindestens ein Trennungsgraben gebildet wird.

17. Verfahren nach Anspruch 15 oder 16,
**dadurch gekennzeichnet, dass**
der Graben und/oder der Trennungsgraben mittels Ätzen hergestellt wird.

18. Verfahren nach einem der Ansprüche 15 bis 17,
**dadurch gekennzeichnet, dass**
freie Oberflächen der Dünnfilmschicht teilweise oder vollständig aufgerauht werden.

## Claims

1. Semiconductor chip for optoelectronics having
- a thin-film layer, in which a zone that emits electromagnetic radiation is formed and which has an emission side, a rear side and side edges that connect the rear side to the emission side, and
- a carrier for the thin-film layer, which is arranged at the rear side and is connected thereto,
at least one electrical front side contact structure being formed on the emission side and at least one trench being formed on the rear side, wherein
- the trench at the rear side defines a single partial region of the thin-film layer which does not overlap the front side contact structure or the trench on the rear side defines a plurality of partial regions which do not overlap the front side contact structure and which are in each case adjacent to at least one region that overlaps the front side contact structure,
- electrical rear side contacts are formed on the rear side only in the partial region or in the partial regions,
- the trench has oblique inner walls with respect to a main plane of extent of the thin-film layer for the purpose of deflecting the electromagnetic radiation, and
- the trench tapers with increasing depth, and the inner walls of the trench have main planes of extent which form an angle of inclination of less than or equal to 45° with a main plane of extent of the thin-film layer.

2. Semiconductor chip according to Claim 1,
**characterized in that**
each partial region of the plurality of partial regions covers an area of greater than or equal to (35 x 35) µm².

3. Semiconductor chip according to Claim 2,
**characterized in that**
each partial region covers an area of greater than or equal to (40 x 40) µm².

4. Semiconductor chip according to one of the preceding claims,
**characterized in that**
the trench has a depth that is less than half a thickness of the thin-film layer.

5. Semiconductor chip according to one of the preceding claims,
**characterized in that**
the trench has a depth of between 0.5 and 3 µm inclusive.

6. Semiconductor chip according to one of the preceding claims,
**characterized in that**
the angle of inclination is between 15° and 35° inclusive.

7. Semiconductor chip according to one of the preceding claims,
**characterized in that**
the side edges run obliquely, at least in an edge region adjoining the rear side, with respect to a main plane of extent of the thin-film layer.

8. Semiconductor chip according to Claim 7,
**characterized in that**
main planes of extent of the obliquely running parts of the side edges are inclined by a sloping angle of greater than or equal to 45° with respect to the perpendicular to the main plane of extent of the thin-film layer.

9. Semiconductor chip according to one of the preceding claims,
**characterized in that**
the front side contact structure is formed in comblike fashion with a plurality of interconnect arms.

10. Semiconductor chip according to Claim 9,
**characterized in that**
the front side contact structure has 4 to 10 interconnect arms inclusive.

11. Semiconductor chip according to one of the preceding claims,
**characterized in that**
the zone that emits electromagnetic radiation is formed in one part.

12. Semiconductor chip according to one of the preceding claims,
**characterized in that**
the free surface of the thin-film layer is partially or completely roughened.

13. Semiconductor chip according to one of the preceding claims,
**characterized in that**
the trench separates the partial region in a main plane of extent of the rear side from the regions which lie opposite the front side contact structure.

14. Semiconductor chip according to one of the preceding claims,
**characterized in that**
the trench runs along edges of the regions which lie opposite the front side contact structure.

15. Method for simultaneously producing a plurality of semiconductor chips for optoelectronics having a thin-film layer, in which a zone that emits electromagnetic radiation is formed, having the following method steps:
- formation of a thin-film layer by epitaxial growth of a layer sequence, containing the zone that emits electromagnetic radiation, on a growth substrate;
- formation of at least one trench in the thin-film layer, wherein the trench tapers with increasing depth, and the inner walls of the trench have main planes of extent which form an angle of inclination of less than or equal to 45° with a main plane of extent of the thin-film layer, in such a way that a single partial region is defined outside regions opposite a contact structure to be produced and that the trench has oblique inner walls with respect to a main plane of extent of the thin-film layer in such a way that the trench on the rear side defines a plurality of partial regions which lie outside regions opposite a front side contact structure to be produced and which are in each case directly adjacent to at least one of these regions or a region that overlaps these regions, and that the trench has oblique inner walls with respect to a main plane of extent of the thin-film layer;
- formation of electrical rear side contacts in the partial region;
- application of the thin-film layer on a carrier substrate in such a way that the trench faces the carrier substrate, and connection of the thin-film layer to the carrier substrate;
- at least partial removal of the growth substrate;
- formation of an electrical front side contact structure on the opposite side of the thin-film layer to the recess; and
- singulation of the assembly comprising carrier substrate and thin-film layer along separating lines to form semiconductor chips.

16. Method according to Claim 15,
**characterized in that**
prior to the application of the thin-film layer on the carrier substrate, at least one separating trench is formed on the rear side along the separating lines.

17. Method according to Claim 15 or 16,
**characterized in that**
the trench and/or the separating trench is produced by means of etching.

18. Method according to one of Claims 15 to 17,
**characterized in that**
free surfaces of the thin-film layer are partially or completely roughened.

## Revendications

1. Dispositif semi-conducteur optoélectronique avec
- une couche en film mince, dans laquelle une zone émettant un rayonnement électromagnétique est formée et qui présente un côté de rayonnement, un côté arrière et des flancs latéraux, qui relient le côté de rayonnement et le côté arrière, et
- un support pour la couche en film mince, qui est disposé sur le côté arrière et qui est assemblé à ce dernier,
dans lequel au moins une structure de contact électrique côté avant est formée sur le côté de rayonnement et au moins une fosse est formée sur le côté arrière, dans lequel
- la fosse sur le côté arrière définit une région partielle unique de la couche en film mince, qui n'est pas en recouvrement avec la structure de contact côté avant ou la fosse sur le côté arrière définit une multiplicité de régions partielles qui ne sont pas en recouvrement avec la structure de contact côté avant et qui sont respectivement voisines d'au moins une région en recouvrement avec la structure de contact côté avant,
- sur le côté arrière, des contacts électriques côté arrière ne sont formés que dans la région partielle ou dans les régions partielles,
- la fosse présente par rapport à un plan d'extension principal de la couche en film mince des parois intérieures inclinées afin de dévier le rayonnement électromagnétique, et
- la fosse se rétrécit avec l'augmentation de la profondeur et les parois intérieures de la fosse présentent des plans d'extension principaux, qui forment avec un plan d'extension principal de la couche en film mince un angle d'inclinaison inférieur ou égal à 45°.

2. Dispositif semi-conducteur selon la revendication 1, **caractérisé en ce que** chaque région partielle de la multiplicité de régions partielles couvre une surface supérieure ou égale à (35 x 35) µm².

3. Dispositif semi-conducteur selon la revendication 2, **caractérisé en ce que** chaque région partielle couvre une surface supérieure ou égale à (40 x 40) µm².

4. Dispositif semi-conducteur selon l'une quelconque des revendications précédentes, **caractérisé en ce que** la fosse présente une profondeur, qui est inférieure à la moitié de l'épaisseur de la couche en film mince.

5. Dispositif semi-conducteur selon l'une quelconque des revendications précédentes, **caractérisé en ce que** la fosse présente une profondeur comprise entre 0,5 et 3 µm, ces deux valeurs comprises.

6. Dispositif semi-conducteur selon l'une quelconque des revendications précédentes, **caractérisé en ce que** l'angle d'inclinaison vaut entre 15° et 35°, ces deux valeurs comprises.

7. Dispositif semi-conducteur selon l'une quelconque des revendications précédentes, **caractérisé en ce que** les flancs latéraux sont inclinés par rapport à un plan d'extension principal de la couche en film mince au moins dans une région des flancs adjacente au côté arrière.

8. Dispositif semi-conducteur selon la revendication 7, **caractérisé en ce que** des plans d'extension principaux des parties inclinées des flancs latéraux sont inclinés d'un angle d'obliquité supérieur ou égal à 45° par rapport à la perpendiculaire au plan d'extension principal de la couche en film mince.

9. Dispositif semi-conducteur selon l'une quelconque des revendications précédentes, **caractérisé en ce que** la structure de contact côté avant est réalisée en forme de peigne avec une multiplicité de bras de voies conductrices.

10. Dispositif semi-conducteur selon la revendication 9, **caractérisé en ce que** la structure de contact côté avant présente 4 à 10 bras de voies conductrices, ces deux valeurs comprises.

11. Dispositif semi-conducteur selon l'une quelconque des revendications précédentes, **caractérisé en ce que** la zone émettant le rayonnement électromagnétique est réalisée en une seule pièce.

12. Dispositif semi-conducteur selon l'une quelconque des revendications précédentes, **caractérisé en ce que** la surface libre de la couche en film mince est partiellement ou entièrement dépolie.

13. Dispositif semi-conducteur selon l'une quelconque des revendications précédentes, **caractérisé en ce que** la fosse sépare la région partielle dans un plan d'extension principal du côté arrière des régions qui sont situées en face de la structure de contact côté avant.

14. Dispositif semi-conducteur selon l'une quelconque des revendications précédentes, **caractérisé en ce que** la fosse s'étend le long de bords des régions, qui sont situées en face de la structure de contact côté avant.

15. Procédé pour la fabrication simultanée d'une multiplicité de dispositifs semi-conducteurs optoélectroniques avec une couche en film mince, dans laquelle une zone émettant un rayonnement électromagnétique est formée, comprenant les étapes suivantes:
- formation d'une couche en film mince par croissance épitactique d'une succession de couches, qui contient la zone émettant un rayonnement électromagnétique, sur un substrat de croissance;
- formation d'au moins une fosse dans la couche en film mince, dans lequel la fosse se rétrécit avec l'augmentation de la profondeur et les parois intérieures de la fosse présentent des plans d'extension principaux, qui forment avec un plan d'extension principal de la couche en film mince un angle d'inclinaison inférieur ou égal à 45°, de telle manière qu'une unique région partielle soit définie à l'extérieur de régions situées en face d'une structure de contact à produire et que la fosse présente des parois intérieures inclinées par rapport à un plan d'extension principal de la couche en film mince ou de telle manière que la fosse définisse sur le côté arrière une multiplicité de régions partielles, qui sont situées à l'extérieur de régions situées en face d'une structure de contact côté avant à produire et qui sont respectivement voisines d'au moins une de ces régions ou d'une région en recouvrement avec ces régions, et que la fosse présente des parois intérieures inclinées par rapport à un plan d'extension principal de la couche en film mince;
- formation de contacts électriques côté arrière dans la région partielle;
- dépôt de la couche en film mince sur un substrat de support, de telle manière que la fosse soit tournée vers le substrat de support, et liaison de la couche en film mince avec le substrat de support;
- enlèvement au moins partiel du substrat de croissance;
- formation d'une structure de contact électrique côté avant sur le côté de la couche en film mince opposé à l'évidement; et
- dislocation du composite composé du substrat de support et de la couche en film mince le long de lignes de séparation en dispositifs semi-conducteurs.

16. Procédé selon la revendication 15, **caractérisé en ce que** l'on forme au moins une fosse de séparation sur le côté arrière le long des lignes de séparation avant le dépôt de la couche en film mince sur le substrat de support.

17. Procédé selon la revendication 15 ou 16, **caractérisé en ce que** l'on produit la fosse et/ou les fosses de séparation par attaque chimique.

18. Procédé selon l'une quelconque des revendications 15 à 17, **caractérisé en ce que** l'on dépolit partiellement ou entièrement des surfaces libres de la couche en film mince.
